(19) Europäisches Patentamt

European Patent Office

Office européen des brevets

(11) **EP 1 420 620 A2**

(12) **EUROPEAN PATENT APPLICATION**

(43) Date of publication:
**19.05.2004 Bulletin 2004/21**

(51) Int Cl.[7]: **H05K 3/00**, C08J 7/12

(21) Application number: **03256768.7**

(22) Date of filing: **27.10.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **28.10.2002 GB 0225012**

(71) Applicant: **Shipley Co. L.L.C.**
**Marlborough, MA 01752 (US)**

(72) Inventors:
• **Cobley, Andrew J.**
  **Coventry, West Midlands CV5 9EY (GB)**

• **Goosey, Martin T.**
  **Galley Common, Nuneaton CV10 9NZ (GB)**
• **Poole, Mark A**
  **Rugby, Warwickshire CV22 7EA (GB)**

(74) Representative: **Kent, Venetia Katherine et al**
**Rohm and Haas (UK) Ltd.,**
**European Patent Department,**
**28th Floor,**
**City Point,**
**One Ropemaker Street**
**London EC2Y 9HS (GB)**

(54) **Desmear and texturing method**

(57) A method for desmearing resin accretions from the surface of a substrate and texturing resins by generating a free radical which attacks and removes the resin accretions and textures the resin.

**Description**

Background of the Invention

The present invention is directed to a solvent free method for desmearing a surface and texturing a resin. More specifically, the present invention is directed to a solvent free method of desmearing a surface and texturing a resin where a free radical is generated to desmear the surface and texture the resin.

Hole forming operations in resin containing materials often result in the smearing of resin over the interior wall or barrel of the hole. This resin smear is primarily attributable to the generation or utilization of temperatures exceeding the melting point of a resinous component of the material during the hole forming process.

Where holes are drilled in epoxy impregnated fiber glass laminate materials, such as those employed to make printed circuit boards, friction of the drill bit against the material raises the temperature of the bit. Often, drill bit temperatures are generated which exceed the melting temperature of many resin systems. The drill bit thus picks up melted resin on its course through the material being drilled, and this melted accretion is smeared in the barrel of the hole. In laser drilling operations to contact interior conductors in organic insulating substrates, a similar resin accretion or smear can develop on the exposed conductor surface.

While the problem of resin smear on the hole walls may be ignored in some applications, it is at times imperative that it be removed such as in the manufacture of multi-layer printed circuit boards. Multi-layer printed circuit boards are used for a variety of electrical applications and provide the advantage of conservation of weight and space. A multi-layer board is comprised of two or more circuit layers, each circuit layer separated from another by one or more layers of dielectric material. Circuit layers are formed by applying a copper layer onto a polymeric substrate. Printed circuits are then formed on the copper layers by techniques well known to the art, for example print and etch to define and produce the circuit traces, i.e., discrete circuit lines in a desired circuit pattern. Once the circuit patterns are formed, a stack is formed comprising multiple circuit layers separated from each other by a dielectric layer, typically a resin-containing material such as epoxy, epoxy/glass or polyimide. Once the stack is formed, it is subjected to heat and pressure to form the laminated multi-layer circuit board. When such a multi-layer circuit board is made, holes are formed in the resin-containing material which includes a plurality of parallel planar metallic conductors, with the hole perpendicular to, and communicating with, two or more parallel metallic conductors. It is often desired to metallize the hole walls in order to form a conductive path between two or more of the metallic conductors. In such instances, the resin smear must be removed from the edges of the hole through the metallic conductors if conductive contact between the metallized hole wall and the metallic conductors is to be achieved. Thus, when circuit board holes are drilled through a copper clad base plastic laminate or through a plastic laminate containing internal conductor planes, such as in a multi-layer circuit board, resin smear on the metallic surfaces exposed to the walls of the holes must be removed to achieve proper functioning of the metallized, or plated, through-holes.

Plated through-holes as described above are useful as electrical connections between printed circuits having metallic conductors on both sides of the plastic laminate or between two or more of the various planes and surface conductor layers in multi-layer boards. The electrical and mechanical integrity required for this function can only be attained by insuring complete removal of resinous materials from the entire inner circumference of the portion of the metallic conductor exposed by the hole.

Numerous methods are known for removing resin smear or resin accretions. One approach is a mechanical one and involves channeling a dry or wet stream of abrasive particles through such holes. A similar method is the use of hydraulic pressure to force a thick slurry of abrasive material through the holes. However, these mechanical methods are generally slow and difficult to control and complete removal of smear in all holes in a given circuit board is difficult to achieve.

Typically, chemical methods are used to desmear holes formed during printed circuit board manufacture. For example, acids such as concentrated sulfuric acid (down to about 90 percent concentration) and chromic acid, have been used to remove smeared epoxy resin. The high acid concentration required is very hazardous and requires extraordinary precautions by operators. When concentrated sulfuric acid is used as a desmear, the hole walls may become unacceptably smooth such that adhesion of an electroless metal layer, such as copper, is unsatisfactory. In addition, the concentrated sulfuric acid rapidly absorbs water, which limits its useful life span and can cause variations in the immersion times required to desmear the holes. Chromic acid also presents toxicity and waste disposal problems, thus presenting an environmental hazard.

The most common chemical resin desmear method uses permanganate, such as potassium or sodium permanganate. For example, U.S. Pat. No. 4,601,784 (Krulik) discloses desmear solutions containing an alkali metal hydroxide, sodium permanganate and from 0.1 to 3.0 moles per mole of permanganate ion of a co-cation selected from potassium, cesium, rubidium and mixtures thereof. The concentrations of sodium permanganate used require the presence of the co-cation. The amount of sodium permanganate used in the baths according to this patent is at least 70 grams per liter of solution. Prior to applying the permanganate etch, the resin is treated with an organic solvent called a solvent swell to soften the resin for ease of the permanganate attack.

Conventional desmear baths typically require a ratio of active permanganate ion concentration to total manganese concentration (as both manganate and permanganate) of 0.6 or greater. When the active:total ratio falls below 0.6, delamination of the plated metal to the substrate may occur. Such failure manifests itself as loss of metal adhesion or blistering of the base dielectric material. When such baths are regenerated, i.e. when the active:total ratio is adjusted to 0.6 or greater, the bath still results in substrates showing delamination with some of the new, advanced dielectric materials. This situation does not hold true for most conventional laminates, i.e., FR4, FR5 and high $T_g$ reinforced laminates.

Additionally, solvent swells may present a hazard to workers. Solvent swells often employ organic solvents, which are toxic and flammable. Accordingly, a method for desmearing without using a solvent swell is highly desirable.

Another problem associated with permanganate based desmear baths is the difficulty of desmearing high $T_g$ (glass transition temperature) resins. Many high $T_g$ resins, $T_g$ values above 155° C, employed in the manufacture of printed wiring and circuit boards are more inert to solvent swells and the desmearing action of permanganate based desmear baths than low $T_g$ resins. Accordingly, desmearing is more difficult and less efficient. Thus, there is a need for a method of desmearing resin accretions without the use of solvent swells and permanganate etch.

EP 0 913 498 discloses a method of texturing a polymer by generating a metal activator such as silver ions ($Ag^{2+}$) which is believed to react with water in a bath to generate hydroxyl radicals which texture or oxidize a polymer substrate. Texturing the polymer substrate prepares a surface of the substrate to receive a metal layer. The textured polymer surface provides a highly desirable morphology for receiving an electrolessly plated metal layer on the polymer surface such that the metal layer is secured to the polymer surface. The metal activators may be generated electrolytically. Such a process is employed in the metallization of plastics.

While the method disclosed in EP 0 913 498 provides a means of texturing a polymer surface to receive a metal layer by electroless plating, the method does not address desmearing resin accretions or smear from throughholes or vias drilled in printed wiring boards. The method for texturing a polymer substrate or resin disclosed in EP 0 913 498 is unsuitable for addressing the desmear problem. Printed wiring boards with through holes having resin accretions are composed of alternating layers of metal, such as copper, and epoxy or other nonconductive board material. Exposing such boards to the texturing method may result in undesirable deposits of metal activator, such as silver, on the copper portions of the board. Such deposits may result in defective printed wiring boards. Another problem associated with the method of EP 0 913 498 is the use of an electrolyte such as nitric acid which may attack certain metals such as copper.

Accordingly, there is a need for an improved method of desmearing resin accretions from through holes or vias and texturing resin in printed wiring boards.

Summary of the Invention

The present invention is directed to a method of desmearing resin smear or accretions from a surface and texturing a resin by generating a free radical which attacks the resin smear or accretions on the surface, thus removing the resin smear and texturing resin.

In one embodiment of the invention a free radical is generated electrolytically in an electroltyte having an anode and a cathode with the substrate to be desmeared immersed in the electrolyte solution. When a current is applied, a free radical is generated at the anode, which attacks resin accretions on a surface of the substrate and textures resin.

In another embodiment of the invention, a free radical may be generated chemically. The free radical then attacks resin accretions to desmear the accretions from a substrate surface and to texture resin.

In an additional embodiment of the present invention, a free radical may be generated by thermolysis. Sufficient heat is applied to a source of a free radical such that the heat applied to the source generates the free radical.

In a further embodiment of the invention, a free radical may be generated by photolysis. Actinic radiation is applied to a source of free radicals to generate the free- radicals which attack resin accretions on a substrate surface and textures resin.

The free radical generating methods of the present invention are suitable in the manufacture of printed wiring boards. Printed wiring boards, such as multi-layer printed wiring boards, are used for a variety of electrical applications and provide the advantage of conservation of weight and space. A multi-layer board is composed of two or more circuit layers, each circuit layer is separated from another by one or more layers or dielectric materials. Circuit layers are formed by applying a copper layer or other suitable metal onto the substrate. Printed circuits are then formed on the copper layers by techniques well known to the art such as print and etch to define and produce the circuit traces, i.e., discrete circuit lines in a desired circuit pattern. Once the circuit patterns are formed, a stack is formed composed of multiple circuit layers separated from each other by a dielectric layer such as a resin-containing material such as epoxy, epoxy/glass or polyimide. Once the stack is formed, it is subjected to heat and pressure to form the laminated multi-layer circuit board. When such a multi-layer circuit board is made, holes or vias are formed in the resin-containing material which includes a plurality of parallel planar metallic conductors, with the hole perpendicular to, and communicating with, two or more parallel metallic conductors. Often the hole wall is metallized in order to form a conductive path between two or more of the metallic conductors. In such instances, resin smear is removed from the edges of the hole through the metallic conductors when conductive contact between the metallized hole wall and the metallic conductors is desired. Thus, when circuit board holes are drilled through a copper clad base plastic laminate or through a plastic laminate containing internal conductor planes such as in a multi-layer circuit board, resin smear on the metallic surfaces exposed to the walls of the holes is removed by a free radical generating method of the present invention to achieve proper functioning of the metallized or plated through-holes. Additionally, the exposed surfaces of the resin layer or plastic laminate layer are textured to receive and form a suitable bond with plated metal.

Plated through-holes are useful as electrical connections between printed circuits having metallic conductors on both sides of the plastic laminate or between two or more of the various planes and surface conductor layers in multi-layer boards. Electrical and mechanical integrity required for this function are attained by removal of resinous accretions from the inner circumference of the portion of the metallic conductor hole.

Advantageously, the method of the present invention eliminates the use of solvent swells employed in desmear methods where a permanganate desmear etch is employed. Conventional desmear methods employ solvent swells to prepare a resin or polymer for treatment with a desmear bath. Such solvent swells often employ hazardous solvents. The method of the present invention eliminates the use of solvent swells and the hazards associated with solvent swells including waste disposal problems of environmentally hazardous chemicals. Thus, the method of the present invention is both worker friendly and environmentally friendly.

Another advantage of the present invention is that the method is especially suitable for desmearing high $T_g$ resins. Such resins or polymers are more inert to solvent swells and permanganate etch than low $T_g$ resins. Both solvent swells and permanganate etches may be eliminated by the method of the present invention, thus the method also reduces chemical consumption. Accordingly, the methods of the present invention provide improved methods for desmearing through-holes and/or vias and texturing resin in the manufacture of printed wiring boards.

A primary objective of the present invention is to provide a method of desmearing resin accretions from a surface with a free radical and texturing a resin.

Another objective of the present invention is to provide a method for desmearing resin accretions and texturing resin of high $T_g$ polymers.

An additional objective of the present invention is to provide a method for desmearing resin accretions and texturing resins without employing a solvent swell or permanganate etch.

Still yet a further objective is to provide a method of desmearing resin accretions from a surface and texturing a resin with reduced chemical consumption.

Additional advantages of the present invention are discernable to a person of skill in the art after reading the detailed description of the invention and the appended claims.

Brief Description of the Drawings

Fig. 1 is a 2000 X SEM of a cross section of a through-hole of an FR4/glass-epoxy printed wiring board showing resin accretions.

Fig. 2 is a 2000 X SEM of a cross section of a through-hole of an FR4/glass-epoxy printed wiring board showing exposed glass where resin accretions were desmeared by free radical generation.

Fig. 3 is a graph of weight loss of resin accretions due to free radical generation over time in an electrolytic cell.

Fig. 4 is an anodic polarization curve of anodic potential versus the log of current density for an iridium dioxide working electrode.

Fig. 5 is an anodic polarization curve of anodic potential versus the log of current density for a lead dioxide working electrode.

Detailed Description of the Invention

As used throughout this specification, the following abbreviations shall have the following meanings, unless the context clearly indicates otherwise: g = gram; mg = milligram; mL = milliliter; L = liter; DI = deionized; ° C = degrees Centigrade; ° F = degrees Fahrenheit; ppm = parts per million; N = normal; cm = centimeter; $dm^2$ = decimeter squared, A = amperes, and wt% = percent by weight.

The terms "printed circuit board" and "printed wiring board" are used interchangeably throughout this specification. All amounts are percent by weight and all ratios are by weight, unless otherwise noted. All numerical ranges are inclusive and are combinable. The terms "resin" and "polymer" are used interchangeably throughout this specification. The terms "smear" and "accretion" are used interchangeably throughout this specification.

The present invention is directed to a method of desmearing resin smears or accretions from a surface and texturing a resin by generating a free radical or active species which attacks the resin accretions to remove them from the surface and to texture resin. The free radical may be any suitable organic or inorganic radical which attacks and removes resin or polymer accretions from a surface and textures a resin. The free radical may be generated by any suitable method such that a free radical is formed to attack and remove resin accretions from a surface. In addition to desmearing the surface of a substrate, the free radical may cause texturing. Examples of such processes for generating a free radical include, but are not limited to, electrolytic generation, chemical generation, generation by thermolysis, or generation by photolysis.

Radicals generated electrolytically may be generated at or near a surface of an anode of an electrolytic cell. Sufficient electrical potential is applied to generate a desired radical. Radicals may vary depending upon the chemical composition of an electrolyte in which the electrodes of the electrolytic cell are immersed. Electrolytes may be defined as an ionic conductor in which current is carried by cations and anions moving in opposite directions. Such electrolytes typically are aqueous based. Advantageoulsy, a worker in the art may readily consult tables of standard electrode potentials and half-reactions to determine the sufficient electrical potential to generate a desired free radical. Such electrical potentials vary depending on the type of radical to be generated. A suitable source of such standard electrode potentials and half-reactions include, but is not limited to, the Atlas of Electrochemical Equilibria in Aqueous Solutions, by Marcel Pourbaix, NACE International Cebelcor, 2nd Edition, 1974. An example of another source of electrode potentials and half-reactions is The Handbook of Chemistry and Physics, 59th edition, 1978-1979 (CRC Press). Other textbooks and source books may be employed provided they disclose the information on standard electrode potentials and half-reactions. Such textbooks and source books are well known by workers in the art. Some undue experimentation may be performed to determine whether or not an electrochemical reaction provides a suitable free radical to desmear and to texture a surface. An example of a suitable free radical is a hydroxyl radical (OH) which may be generated from an aqueous solution. A free-radical is an atom or group of atoms possessing an odd electron (unpaired electron). The free-radical has no charge. Hydroxyl radicals are highly reactive short-lived species that attack and destroy many organic substances either as solids or present in aqueous solution. To generate a hydroxyl free radical, a sufficient thermodynamic electrical potential is applied by an electrical source to an electrolytic cell such that the electrical potential exceeds the potential at which oxygen evolves. Such a potential may vary depending on the material that the anode of an electrolytic cell is composed of and the pH of the electrolyte. For example, the oxygen evolution potential for lead dioxide in an aqueous solution of pH 1 is 1.6 to 2.0 V (versus standard hydrogen electrode (SHE)). However, if an iridium dioxide anode is used in the same electrolyte the oxygen evolution potential is 1.3 to 1.5 V (versus SHE).

Oxygen evolution potential may be determined by performing an anodic polarization scan in a particular electrolyte and with a particular anode. Many different electrolytes are well known in the art. Examples of suitable anodes are described below. An anodic polarization scan may be carried out by using a cell with a desired electrolyte, counter electrode, a working electrode which is the particular anode under test and a reference electrode such as a saturated calomel electrode (SCE) or a saturated hydrogen electrode (SHE). Such cells are typically three chambered. A central chamber contains an anode under test or working electrode. The anode under test is the anode with which the potential for oxygen evolution is determined. The potential for oxygen evolution varies with the material which the anode in made of as well as the electrolyte and pH of the electrolyte. The central cell is in fluid communication by means of an electrolyte with a second chamber containing a counter electrode and a third chamber containing the reference electrode.

The anodic potential of the working electrode is gradually increased using a potentiostat. As the anodic potential is gradually increased the resultant current density is measured and an anodic polarization curve is made of anodic potential versus log of the current density. A wave or line which is nearly horizontal indicates a rapid increase in current density. Such a wave indicates that an electrochemical reaction is occurring at the anode such as the evolution of oxygen. The potential at which the wave begins is the potential at which oxygen evolves. Typically bubbles are given off at the anode surface indicating oxygen evolution. When an electrochemical reaction occurs at the anode, an increase in the flux of electrons at the anode results and this in turn causes an increase in current density. By reference to an appropriate Pourbaix diagram and noting the potential at which the wave begins, the potential at which evolution of oxygen occurs is readily determinable.

Pourbaix diagrams are well known in the art. Such diagrams are electrical potential-pH diagrams for a particular metal in a solution such as water. The Pourbaix diagrams show the stability of a particular metal at a given pH and electrical potential. Such diagrams guide a worker to determine if a particular metal may be used as an anode at a pH and electrical potential without substantial corrosion. A detailed description of Pourbaix diagrams may be found in the Atlas of Electrochemical Equilibria in Aqueous Solutions, by Marcel Pourbaix, NACE International Cebelcor, 2nd Edition, 1974.

Any suitable anode that favors generation of a free radical which attacks and desmears a surface and textures a resin may be employed to practice the present invention. For example, suitable anodes that favor generation of hydroxyl radicals are anodes composed of material which may not form a higher oxide above the thermodynamic potential for oxygen evolution. Workers in the art may refer to tables from sources, as described above, which list electrical potentials and half-reactions to determine if a particular material is suitable for generating a desired free radical such as the hydroxyl radical. Specific potentials are determined with respect to a reference electrode as described above. For example, inert anodes such as lead dioxide ($PbO_2$) are preferably employed as an anode to generate hydroxyl radicals because lead dioxide does not form a higher oxidation state such as lead trioxide at potentials above the thermodynamic potential at which oxygen evolution occurs. Other suitable inert anodes that may be employed to generate hydroxyl radicals include, but are not limited to, boron doped diamond (BDD), graphite carbon and tin dioxide.

Any suitable cathode may be used to practice the present invention. Examples of such cathodes include, but are not limited to, copper, platinum, platinized titanium, lead dioxide, oxides of iridium, ruthenium, tin, and tantalum and mixtures of these material. Other suitable materials for cathodes include, but are not limited to, cobalt, nickel, rhodium, palladium, zirconium, hafnium, vanadium, aluminum, zinc, iron or niobium and their oxides, and mixtures of these materials.

Electrolytic generation of free radicals involves employing an electrochemical cell. Central to the operation of the cell is the occurrence of oxidation and reduction reactions which produce electrons. These reactions take place at electrode/electrolyte interfaces. In operation, an electrochemical cell is connected to an external load or to an external voltage source, and electric charge is transferred by electrons between an anode and a cathode through the external circuit. To complete the electric circuit through the cell, an additional mechanism exits for internal charge transfer. This is provided by one or more electrolytes which support charge transfer by ionic conduction. Various suitable electrolytes are well known in the art.

A positively charged anode and a negatively charged cathode are submerged in the electrolyte with electrical leads leading to the exterior. Electrolytes within the scope of the present invention have a pH range of from 1.0 to 13.0, preferably 1.0 to 7.0, most preferably from 3.0 to 5.0. The cell has appropriate plumbing and external structures to permit circulation of the electrolyte to a separate heat exchanger. Suitable inlet and outlet passages are also provided in the cell to permit withdrawal of gases evolved from the anode. In order to maintain or cool the electrodes, heat exchange passages may be provided within the electrode structures. Such coolant passages are connected to external sources of coolant liquid, such as water, which can be circulated through the electrodes during electrolysis in order to maintain or reduce their temperatures. In order to minimize heating effects within the electrolysis of the cell and, hence, to lower the consumption of electrical energy, the positive and negative electrodes are placed as close as possible to each other without short circuiting taking place. In order to minimize the space between the positive and negative electrodes, a separator material may be placed between them. Separators are thin film materials, either inorganic (asbestos) or organic such as microporous (polyethylene polymer material such as the material sold by Daramic Inc. of Lexington, Mass. under the trademark DARAMIC or CELGARD) in nature, and are electrical insulators containing microporous channels or pathways that allow flow of ions through the material.

The electrodes are connected through the electrical leads to an external source of electric power with the polarity being selected to induce the electrolyte anion flow to the anode and the cation flow to the cathode. Application of a DC source of electrical energy to two electronically conducting electrodes immersed in an aqueous electrolytic can generate free radicals which attack and desmear resin accretions and texture a resin. Anode current densities may range from at least 1 A/dm$^2$, preferably from 5 A/dm$^2$ to 100 A/dm$^2$, and most preferably from 10 A/dm$^2$ to 15 A/dm$^2$.

In addition to generating hydroxyl free radicals from water at or near an anode, other ionic species in an electrolyte also may be oxidized during current generation to form free radical species that may contribute to resin desmear and resin texturing. Examples of such ionic species that may be oxidized to form free radicals include, but are not limited to, chloride, bromide, fluoride or iodide. Sources for such free radicals include, but are not limited to, water-soluble salts such as alkali metal salts. Alkali metal salts of chloride such as sodium chloride and potassium chloride are preferred along with the alkali metal salts of bromide such as sodium and potassium bromide. Alkali metal salts that form ionic species which may be anodically oxidized to form free radicals that desmear resin accretions and texture a resin range from 1 to 35 grams/Liter of an electrolyte, preferably from 10 to 20 grams/Liter of an electrolyte. Such free radicals may be generated at thermodynamic potentials below or above the thermodynamic potential of oxygen. Such potentials may readily be determined by a person of skill in the art by referring to tables of electrical potentials and half-reactions for a given species.

Examples of other components in electrolytes include, but are not limited to, mineral acids such as sulfuric acid, phosphoric acid, tetrafluoroboric acid, hexafluorophosphoric acid, or mixtures thererof. Also, such acids as phosphonic, sulfonic, perfluoro bis-sulfonimides and corresponding carbanion acids in monomeric, dimeric, or oligomeric forms, or mixtures thereof may be employed. Such acids compose from 10% by weight to 50% by weight of the electrolytic solution. Water-soluble metal salts such as salts of copper, nickel, zinc, gold, silver, platinum, or cobalt may be employed. Examples of exemplary copper metal salts include, but are not limited to, copper sulfate monohydrate and copper sulfate pentahydrate. Metal salts compose from 30% to about 50% by weight of the electrolyte. In addition, electrolytes also include conventional adjuvants well known in the art which assist in electrolytic processes such as in metal plating. The balance of electrolyte is brought to 100% by weight with water. Electrolytic processes of the present invention may be performed at temperatures of from 18° C to 25° C for periods of from 1 minute to 20 minutes, typically from 5 minutes to 15 minutes.

Another method of generating hydroxyl free radicals is by photolysis. Hydroxyl radicals may be generated by photolysis using a combination of ozone and UV light, or hydrogen peroxide and UV light, or the combination of ozone, hydrogen peroxide and UV light. Ozone, also known as triatomic oxygen ($O_3$), when employed as a resin desmear is generated and used for treatment immediately. Ozone is unstable and may not be stored. Commercially available equipment may be used to generate hydroxyl radicals from hydrogen peroxide and/or ozone. Ozone may be generated at UV wavelengths of from 200 nm to 450 nm. Preferably ozone is generated at a UV absorbance at or near 254 nm. UV radiation applied to ozone generates an excited oxygen atom as follows:

$$O_3 + UV \rightarrow O_2 + O\text{* (an excited oxygen atom)}$$

The excited oxygen atom may then generate hydroxyl radicals in one of two ways. The excited oxygen atom may react with water as follows:

$$O\text{*} + H_2O \rightarrow 2 \cdot OH \text{ (hydroxyl radicals)}$$

or, they may react with water to form hydrogen peroxide, which then reacts with UV radiation to form hydroxyl radicals as follows:

$$O\text{*} + H_2O \rightarrow H_2O_2$$

$$H_2O_2 + UV \rightarrow 2 \cdot OH$$

Other alternative reactions also may take place. Advantageously, high concentrations of both hydrogen peroxide and ozone may be avoided. Hydrogen peroxide may be used within a range of 0.1 to 10.0 grams/liter, preferably from 1 to 5 grams/liter. Ozone concentrations may range from 0.1 to 50 grams per hour, preferably from 1 to 20 grams per hour. Oxidation rates achieved using hydroxyl radicals are greater than those attainable from hydrogen peroxide and ozone alone or other oxidants such as hydrogen peroxide with chlorine, hypochlorite, or $TiO_2$ in the presence of UV light because of the very high reactivity of the hydroxyl radical. Reaction rates achieved using hydroxyl radicals may range from $10^6$ to $10^9$ times greater than reaction rates achieved using ozone alone.

Ozone may be generated by any suitable method known in the art. Any suitable commercially available ozone generator and a short wavelength UV exposure unit (200 nm to 450 nm) may be employed to practice the present invention. For example, a suitable ozone generator that may be employed is a CD-10/AD unit supplied by RGF $O^3$ Systems of West Palm Beach, Florida, U.S.A., which produces ozone by a corona discharge route. UV exposure units also may be obtained from RGF $O^3$ Systems, but other similar equipment may be equally suitable.

An example of one method of generating ozone is to continuously circulate water between two holding tanks. The holding tanks are joined by a quartz tube inside a UV exposure unit, and water passes through the quartz tube from one tank to the other. Ozone is introduced into the water via a venturi or other suitable apparatus. Substrates to be desmeared and textured are immersed in water in the exposure unit where hydroxyl radicals generated from ozone by UV light exposure attack resin accretions. Ozone may be enhanced by using oxygen instead of air in the ozone generator. When oxygen is used, the concentration is from 95 to 99.9% pure. The flow rate of the oxygen is 0.5 liters/minute to 1 liter/minute.

In another method, generated ozone is pumped into an aqueous solution or bath containing a substrate for resin accretion desmearing and resin texturing through an ozone diffuser. An ozone diffuser may be a stone of fine porosity, which creates small bubbles that rise through the aqueous solution. The slower the bubbles rise through the aqueous solution, the greater the amount of ozone produced in the solution. Such ozone diffusers are well known in the art. Under the influence of UV radiation, ozone breaks down to form oxygen and an excited oxygen atom. Excited oxygen atoms then react with water to form either hydroxyl radicals directly or form hydrogen peroxide which reacts with the UV radiation to form hydroxyl radicals. The solution containing the generated hydroxyl radicals may then be pumped into a module containing a substrate for resin accretion desmearing and resin texturing. The ozone and hydrogen peroxide processes may be performed at temperatures of from 18° C to 25° C for a period of from 1 minute to 20 minutes, typically from 5 minutes to 15 minutes.

In another embodiment of the present invention, a free radical may be generated chemically as opposed to electrolytically or by photolysis. An example of a chemical process of producing a radical is the use of Fenton's reagent, which is composed of hydrogen peroxide and a ferrous iron source. Fenton's reagent, which is added to an aqueous solution, generates hydroxyl radicals that attack resin accretions on the surface of the substrate immersed in the aqueous solution and textures resin. The process may be performed at temperatures of from 18° C to 25° C. Desmearing and texturing times may range from 1 minute to 20 minutes, typically from 5 minutes to 15 minutes.

While the method of the present invention may be used without etching, a promoter or oxidizing etch optionally may be employed. Etching compositions are well known in the art. An example of a suitable etching composition is the permanganate etch. Such permanganate etch solutions include one or more permanganate ion sources, one or more hydroxide ion sources and water. Any permanganate ion source that is at least partially water-soluble or water-dispersable may be used. Suitable permanganate ion sources include, but are not limited to, alkali metal permanganates such as sodium permanganate and potassium permanganate. Mixtures of permanganate ion sources may be used. The permanganate ion sources useful are generally commercially available and may be used without further purification.

The permanganate ion sources may be employed in an amount such that the concentration of permanganate ion is from 30 to 75 grams/liter, based on the concentration of active permanganate ion in the composition. Preferably, the amount of active permanganate ion is present in an amount of from 45 to 60 grams/liter. For example, when sodium permanganate is used, it is present in an amount of from 45 to 60 grams/liter. Total manganese concentration as manganate and permanganate ions is in the range of from 40 to 95 grams/liter, preferably from 50 to 85 grams/liter and more preferably from 55 to 70 grams/liter. Ratios of active permanganate ion concentration to total manganese concentration is 0.6 or greater, preferably 0.7 or greater, and more preferably 0.8 or greater.

Any suitable alkali metal hydroxide or alkaline earth metal hydroxide may be used in the present invention as the hydroxide ion source. Preferably, the hydroxide ion source is an alkali metal hydroxide. Suitable alkali metal hydroxides include lithium hydroxide, sodium hydroxide, potassium hydroxide, rubidium hydroxide, and cesium hydroxide. Preferably, the hydroxide ion source is sodium hydroxide or potassium hydroxide. Mixtures of hydroxide ion sources also may be used. Hydroxide ion sources that are useful are commercially available and may be used without purification.

Hydroxide ion sources are used in the promoter compositions in an amount such that the concentration of hydroxide ion is from 25 to 60 grams/liter, based on the volume of the composition. Preferably, the hydroxide ion concentration is from 35 to 55 grams/liter, and more preferably from 40 to 50 grams/liter.

The amounts of both the permanganate ion sources and hydroxide ion sources refer to the amounts of such components present in solution for a given bath. Likewise, the amounts of permanganate ions and hydroxide ions refer to the amounts of such ions present in the promoter composition.

In addition to a promoter composition, a neutralizer may be used in conjunction with the free radical and promoter composition. Neutralizers oxidize any residues from the promoter left on the substrate after resin accretion desmearing. Permanganate promoters leave residues of permangante and manganate. Many neutralizers are commercially available and are well know in the art. Examples of such neutralizers are amine salts such as hydroxylamine and alkyl hydroxylamine salts, or hydrogen peroxide.

While the method of the present invention may be employed to desmear and texture low $T_g$ resins, below 155° C from a substrate surface, the method of the present invention also is suitable for desmearing resin accretions and texturing resins of high $T_g$ resins and polymers. $T_g$ values for high $T_g$ resins and polymers exceed 155° C. Such resins include, but are not limited to, polyimides, polyepoxies, polyesters, or polyurethanes with a $T_g$ value over 155° C. Many such high $T_g$ resins exceed 160° C. Many epoxy blends may have a $T_g$ of 220° C. New polymer materials are on the market which have a $T_g$ higher than 220° C. Examples of such high $T_g$ polymers include, but are not limited to cyannate ester, alkylated polyphenylene ester or epoxy blends.

Free radical generating methods of the present invention are suitable in the manufacture of printed wiring boards. Printed wiring boards, such as multi-layer printed wiring boards, are used for a variety of electrical applications and provide the advantage of conservation of weight and space. A multi-layer board is composed of two or more circuit layers, each circuit layer is separated from another by one or more layers or dielectric materials. Circuit layers are formed by applying a copper layer or other suitable metal, such as copper alloys, nickel, nickel alloys or other suitable metal or metal alloy, onto the substrate. Printed circuits are then formed on the copper layers by techniques well known to the art such as print and etch to define and produce the circuit traces, i.e., discrete circuit lines in a desired circuit pattern. Once the circuit patterns are formed, a stack is formed composed of multiple circuit layers separated from each other by a dielectric layer such as a resin-containing material such as epoxy, epoxy/glass or polyimide. Once the stack is formed, it is subjected to heat and pressure to form the laminated multi-layer circuit board. When such a multi-layer circuit board is made, holes or vias are formed in the resin-containing material which includes a plurality of parallel planar metallic conductors, with the hole perpendicular to, and communicating with, two or more parallel metallic conductors. Often the hole wall is metallized in order to form a conductive path between two or more of the metallic conductors. In such instances, resin smear is removed from the edges of the hole through the metallic conductors when conductive contact between the metallized hole wall and the metallic conductors is desired. Thus, when circuit board holes are drilled through a copper clad base plastic laminate or through a plastic laminate containing internal conductor planes such as in a multi-layer circuit board, resin smear on the metallic surfaces exposed to the walls or surface of the holes is removed by a free radical generating method of the present invention to achieve proper functioning of the metallized or plated through-holes. Additionally, the exposed surfaces of the resin layer or plastic laminate layer are textured to receive and form a suitable bond with plated metal.

Plated through-holes are useful as electrical connections between printed circuits having metallic conductors on both sides of the plastic laminate or between two or more of the various planes and surface conductor layers in multi-layer boards. Electrical and mechanical integrity required for this function are attained by removal of the plastic laminate resin accretions from the inner circumference of the portion of the metallic conductor hole. The resin is to be desmeared is picked up by a drill bit during the drilling of the through-holes and then redeposited onto a metal inner layer as a thin film of smear. During the desmear process this thin film is removed from the inner layer. A thin surface layer of the resin from the plastic laminate may also be removed leaving an underlying layer of resin textured.

Substrates containing resin smear may be processed by any of the foregoing described methods or combinations of methods described above. For example, in the manufacture of a printed wiring board ("PWB"), the following steps may be employed:

1. The PWB is precleaned before treatment by any suitable cleaning solution. Such precleaning removes oils or dirt, and helps uniformly wet the substrate surfaces, both resin and metal.

2. The cleaned PWB is then rinsed to remove the cleaning solution.

3. The rinsed PWB is then desmeared by generating a free radical by a method of the present invention for a time sufficient to effect the desired resin removal and resin texture. Optionally, a permanganate etch may be employed to assist in desmearing and texturing. The actual conditions employed will vary with the type of desmearing and texturing desired, as described above. Permanganate etch is typically employed at temperatures of from 70° C to 100° C.

4. The rinsed PWB is then contacted with an acid neutralization solution, such as dilute sulfuric acid and hydrogen peroxide, to remove substantially all of the permanganate and manganese residues from the board.

5. After acid neutralization, the PWB is again rinsed. The PWB is then ready for subsequent metallization.

A further advantage of the present invention is that substrates, such as printed wiring boards, are obtained having increased peel strength as compared to boards processed using conventional desmear and etch baths. Such increased peel strengths are obtained when lower total permanganate ion concentrations are used, such as up to about 40 g/L. Thus, the present invention provides a method for providing substrates having improved peel strength including the step of contacting the substrates with a composition including one or more permanganate ion sources, one or more hydroxide ion sources and water, wherein the hydroxide ion is present in an amount of from about 25 to about 85 g/L and wherein the composition has a total manganese ion concentration of from about 15 to about 40 g/L. In addition to having increased peel strengths, such substrates also are effectively desmeared.

The methods of the present invention eliminate the use of solvent swells, thus eliminating the toxic and flammable hazards associated with solvent swells. Accordingly, the method of the present invention is worker friendly and environmentally friendly. Additionally, etching with chemical etchants may be avoided to further reduce chemical expenditure in desmearing and texturing processes. A further advantage of the present invention is that total process yields are improved as compared to processes using solvent swells and conventional desmear baths.

While the present invention has been described with respect to printed wiring board processes, the present invention also may be applied to any resinous substrate.

The following examples are intended to illustrate further various aspects of the present invention, but are not intended to limit the scope of the invention in any aspect.

Example 1

An electrolytic cell was made with a lead dioxide anode and an iridium dioxide cathode. The electrolyte of the cell was prepared with 30 grams/liter of sodium hydroxide in DI water. The bath was maintained at 20° C.

A second bath was prepared by combining 48 grams/liter of sodium hydroxide and DI water. To this was added 55 grams/liter of sodium permanganate and the bath was made up to volume. The bath was heated at 85° C.

An FR4 10 multi-layer printed wiring board substrate containing glass reinforced epoxide resinous layers, copper inner-layers and through-holes in the board (control board) with resin accretions was placed in the electrolytic cell for 10 minutes but no current was applied. The substrate was then removed and rinsed with water for 3 minutes. The board was then placed in the permanganate bath for 10 minutes and then rinsed with water for 6 minutes. The board was then placed into a bath at 50° C for 3 minutes containing a neutralizer to neutralize permanganate and manganate residues left on the board from the permanganate solution. The neutralizer contained hydroxylamine as the active component.

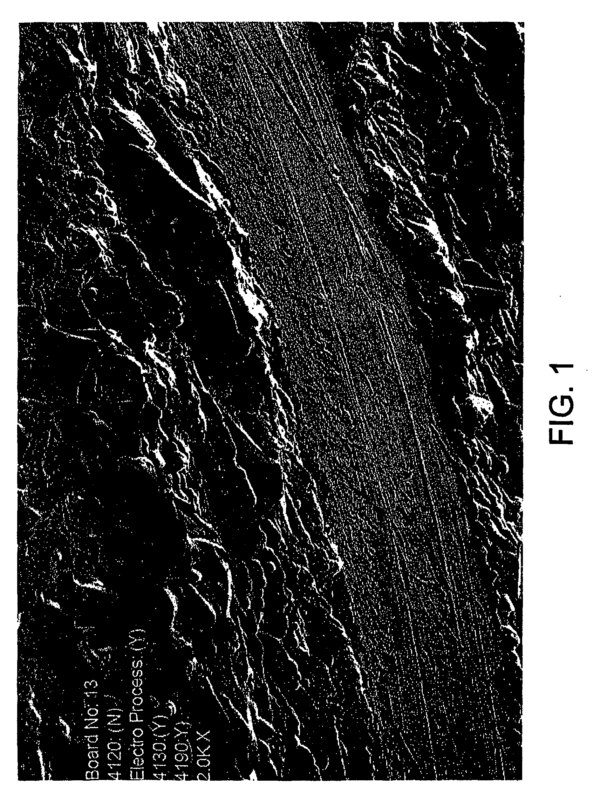

After neutralization of the board, the board was rinsed for 3 minutes in water, dried and then examined using a scanning electron microscope to determine the amount of resin smear on the walls and inner layers of the through-holes. Fig. 1 shows a SEM (scanning electron micrograph) of a cross section of a wall of a through-hole of the treated board with copper layers. Texturing was observed on both sides of the copper inner-layer (distinct band from side to side in the SEM). Although some resin smear was removed from the copper inner-layer, resin smear removal was poor. Clean glass fibers were not observed along the through-hole wall.

A second FR4/glass-epoxy 10 layer, multi-layer board was treated in exactly the same manner as described above except that the anode and cathode of the electrolytic cell were electrically connected to a DC electric source and an anode current density of 11.4 A/dm$^2$ was applied for 10 minutes. The potential exceeded the potential for oxygen evolution. The temperature of the bath was 20° C. After 10 minutes of applying the current, the board was removed from the electrolytic cell and rinsed for 3 minutes with water. The board was then immersed into the promoter bath as described above for 10 minutes at 85° C, rinsed in water for 6 minutes, treated with the neutralizer described above for 3 minutes at 50° C and rinsed with water for 3 minutes. A scanning electron micrograph of the through-holes of the board was done to observe the performance of the desmearing process. No smear was observed on the copper inner-layer, exposed glass or walls of the through-holes that were examined.

A third FR4/glass-epoxy 10 layer multi-layer board was immersed into an electrolytic bath containing 30 grams/Liter of sodium hydroxide electrolyte. DC current was applied for 10 minutes at 20° C. The anode was an inert lead dioxide anode and the cathode was of iridium dioxide. The anode current density was 22.8 A/dm$^2$, and the potential exceeded the potential for oxygen evolution. After 10 minutes the board was removed from the electrolytic cell, rinsed for 3 minutes in water, and placed in the promoter bath described above. The board remained in the bath for 10 minutes at 85° C, rinsed in water for 6 minutes then treated with the neutralizer described above for 3 minutes at 50° C. The board was then rinsed with water for 3 minutes, and the through-holes were examined for resin accretion desmearing.

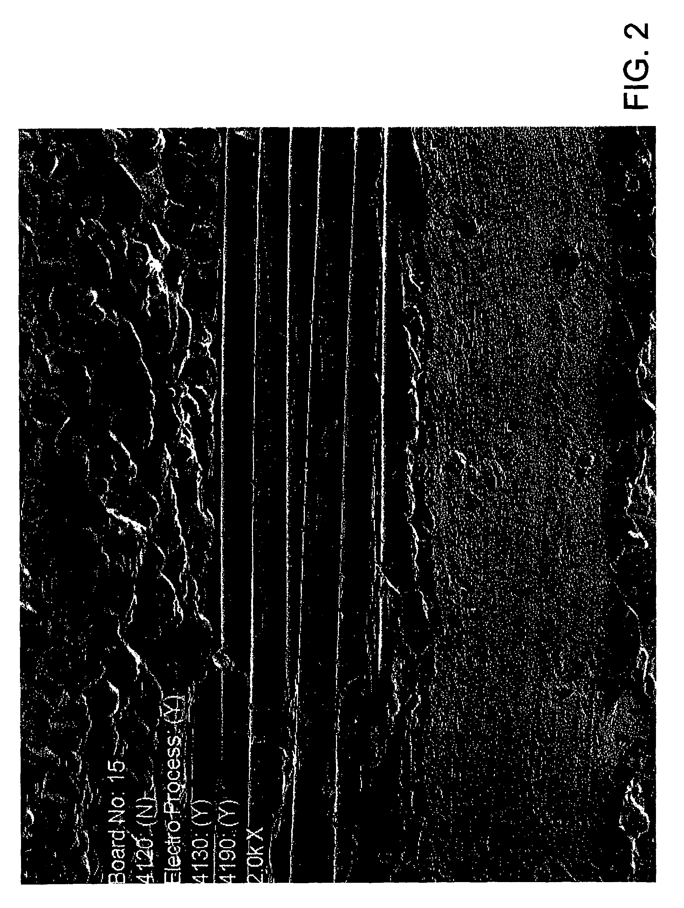

The through-holes were examined under a scanning electron microscope. Most of the through-holes that were examined showed no resin smear. The number of through-holes with no resin smear increased in contrast to the number of through-holes desmeared in the board treated at an anode current density of 11.4 A/dm$^2$. In addition the amount of exposed glass had increased indicating that increased resin removal was observed with increased current density. Figure 2 shows a typical hole wall with an inner-layer. There is no smear on the inner layer. Texturing is visible at the top of the SEM with clear exposed glass followed by a clear copper band.

A fourth board was treated by the same method as the second and third boards except that the electrolytic bath contained chloride at a concentration of 5 grams/Liter in addition to the 30 grams/Liter of sodium hydroxide. Chloride was added to the electrolytic bath in the form of sodium chloride. The anode current density was 11.4 A/dm$^2$, and the potential exceeded the potential for oxygen evolution. After treatment, the board was analyzed for resin accretions using a scanning electron microscope. The through-holes that were examined for resin accretions showed good texturing and no resin smear on the copper inner-layers, exposed glass or along the walls of the through-holes.

A fifth board was treated according to the method of the present invention as board four with the exception that the chloride concentration was increased to 10 grams/Liter and the anode current density was increased to 22.8 A/dm$^2$. The through-holes of the board were examined for resin accretion desmearing using a scanning electron microscope. No smear was observed on the copper inner-layers, exposed glass or hole walls. The amount of exposed glass also had increased indicating increased resin removal and the resin texturing was good.

The table below summarizes the results of the experiments that were done on resin accretion removal.

Table 1

| Electrolytic Cell Conditions | Electrolytic Cell Conditions | SEM Examination |
|---|---|---|
| Chloride Ion Concentration (grams/ Liter) | Anode Current Density (A/ dm$^2$) | |
| None | None | Some smear |
| None | 11.4 | No smear |
| None | 22.8 | Increased resin removal - no smear |
| 5 | 11.4 | Good texturing - no smear |
| 10 | 22.8 | Good texturing and resin removal - no smear |

The experiments showed that immersing a printed wiring board in an electrolytic cell desmeared resin accretions from through-holes in the board. Workers believed that the application of a current when the board was immersed in an electrolyte solution generated hydroxyl free radicals which attacked the resin accretions in the through-holes which in combination with the permanganate bath desmeared the through-holes. Desmearing the through-holes by means of free radicals improved the desmear process over the use of permanganate desmearing alone as shown by the improved desmearing results in Table 1 and the figures.

As the anode current density was increased from 11.4 A/dm$^2$ to 22.8 A/dm$^2$ the amount of resin removal increased as contrasted between board three and board two. As the current density was increased the workers believed that more hydroxyl radicals were generated. The addition of chloride in the form of sodium chloride to the electrolyte bath further improved desmearing by texturing the glass-epoxy wall surface while at the same time removing resin accretions. Workers believed that chloride radical species also attacked and desmeared resin accretions during application of the electric current through the electrolyte bath. Thus, the methods of the present invention were an improvement over chemical etching.

Example 2

Unclad FR4/glass-epoxy and Unclad N-6 FC/epoxy panels were tested for resin weight loss using the method of the present invention. The FR4/glass-epoxy panels had $T_g$ values of from 130° C to 140° C. The N-6 FC/epoxy panels had $T_g$ values of 175° C. Each panel was 6 cm x 2 cm. Each panel was baked in an oven at 120° C for 6 hours and then weighed prior to the process described below.

An electrolytic cell was made up with a lead dioxide anode and a copper cathode. The electrolyte was composed of 80 grams/liter of copper sulfate pentahydrate and 225 grams/liter of sulfuric acid.

A bath was prepared by combining 48 grams/liter of sodium hydroxide and DI water, such that the concentration of the caustic was 1.2 N. To this was added 55 grams/liter of sodium permanganate and made up to volume with DI water. The bath was heated to 85° C.

A pair of panels were placed in the electrolytic cell for 10 minutes but no current was applied. The panels were then removed from the cell and rinsed for 3 minutes with water. Each panel was placed in the permangante bath for 10 minutes. Each panel was then removed from the bath and rinsed with water for 6 minutes and then immersed in a bath of a neutralizer composed of 5.5% by weight sulfuric acid and 1.2% by weight hydrogen peroxide for 3 minutes at 20° C to neutralize permanganate and manganate residue left on each panel after permanganate etching. Each panel was then rinsed with water for 3 minutes at 20° C, dried in an oven for 6 hours at 120° C and then weighed. The weight of each panel decreased due to permanganate etching. Table 2 below records the weight loss for each panel.

Another pair of panels, FR4/glass-epoxy and N-6 FC/epoxy, were dried in an oven as previously described weighed and then immersed into an aqueous electrolyte of the electrolyte cell described above but in this case an anode current density of 11.4 A/dm$^2$ was applied for 10 minutes. The potential exceeded the potential for oxygen evolution. The electrolyte solution was maintained at 20° C during current application. Each panel was then removed from the solution and rinsed with water for 3 minutes. Each panel was then immersed in a permanganate etch as described above for 10 minutes, rinsed with water for 6 minutes and then immersed in a solution of neutralizer of 5.5% by weight sulfuric acid and 1.2% by weight hydrogen peroxide for 3 minutes at 20° C. Each panel was then rinsed with water for 3 minutes and dried at room temperature. The panels were oven dried and their weight loss was determined and recorded in the table below.

A third pair of FR4/glass-epoxy and N-6 FC/epoxy panels was treated as the second pair described above except that the electrolyte also contained 5 grams/liter of chloride ion from sodium chloride. The weight loss for each panel was recorded and is in the table below.

Table 2

| Electrolytic Cell Conditions | Electrolytic Cell Conditions | FR4/glass-epoxy Panel | N-6 FC/epoxy Panel |
|---|---|---|---|
| Chloride Concentration (grams/Liter) | Anode Current (A/dm$^2$) | Weight Loss (mg/cm$^2$) | Weight Loss (mg/cm$^2$) |
| None | None | 0.3135 | 0.4292 |
| None | 11.4 | 0.3162 | 0.4576 |
| 5 | 11.4 | 0.4370 | 0.5408 |

Panels treated in the electrolytic cell with applied current but without sodium chloride had a weight loss increase of 0.0027 (FR4/glass-epoxy) and 0.0284 (N-6 FC/epoxy) over their respective panels only treated with the permanganate etch. Panels treated in the electrolytic cell where sodium chloride was added showed additional weight loss over the panels etched with permanganate, and the panels treated in the electrolyte bath without sodium chloride. The difference in weight loss between the panels only etched with permaganate and the panels treated in the electrolyte with sodium chloride was 0.1235 (FR4/glass-epoxy panels) and 0.1116 (NC-6 FC/epoxy). The weight loss increase in the panels treated in the electrolyte containing sodium chloride over the panels treated in the electrolyte without sodium chloride was 0.1208 (FR4/glass-epxoy) and 0.0832 (NC-6 FC/epoxy).

The results of the tests showed that application of an electric current to a solution increases the amount of resin removed from a panel over permanganate etch alone. By the addition of chloride ion to the electrolyte, resin removal is further increased. Accordingly, the methods of the present invention showed improved resin accretion desmearing.

Example 3

Unclad FR4/galss epoxy and unclad N-6 FC/epoxy panels were tested for resin weight loss using a method of the present invention. The FR4/glass-epoxy panels had $T_g$ values of from 130° C to 140° C. The N-6 FC/epoxy panels had Tg values of 175° C. Each panel was 1.3 cm x 7.0 cm. Each panel was baked in an oven at 120° C for 6 hours and then weighed prior to the process described below.

An electrolytic cell was made up with a 7.5 cm x 5 cm double-sided lead dioxide anode and a 7.5 cm x 5 cm double-sided copper cathode. The electrolyte was composed of 225 grams/liter of sulfuric acid and 80 grams/liter of copper sulfate pentahydrate.

A bath was prepared by combining a 1.1 N aqueous sodium hydroxide solution with a solution of 55 grams/liter of sodium permanganate and made up to volume with DI water. The bath was heated to 85° C.

Five pairs of panels were placed in the electrolytic cell with an 11.4 A/dm$^2$ current density being applied. The potential exceeded the potential for oxygen evolution. A pair of panels, one an FR4 and one an N-6 panel, was removed from the electrolytic cell at time periods of 0, 5, 10, 20 and 30 minutes. Current was not applied for the pair of panels at the 0 time increment. The panels were rinsed for 3 minutes with water.

Each panel was then placed in the permanganate bath for 10 minutes. Each panel was then removed from the bath and rinsed with water for 6 minutes and then immersed in a bath of neutralizer composed of 1.2% by weight hydrogen peroxide and 5.5% by weight sulfuric acid for 3 minutes at 20° C to neutralize permanganate and manganate residue left on each panel after permanganate etching. Each panel was then rinsed with water for 2 minutes at 20° C, air-dried. The panels were then baked as described above and weighed. The weight difference between the panels before and after treatment is recorded in the table below.

Another set of five pairs of panels, FR4/glass-epoxy and N-6 FC/epoxy, were dried in an oven as previously described, weighed and then immersed into an aqueous electrolyte of an electrolytic cell described above except the electrolyte contained 5 grams/liter of sodium chloride in addition to sulfuric acid and copper pentahydrate. A pair of panels was placed in the electrolyte cell for time periods of 5, 10, 20, and 30 minutes with the current density applied. The pair of panels for the 0 time increment was placed in the electrolyte without current application. The panels were further treated as the first set of panels described above. The weight loss for each panel was recorded and the weight losses are disclosed in the table below.

Table 3

| Electrolytic cell conditions | | FR4 Panels |
| --- | --- | --- |
| Time (minutes) | NaCl conc. (g/l) | Weight loss mg/cm$^2$ |
| 0 | 0 | 0.4319 |
| 5 | 0 | 0.4511 |
| 10 | 0 | 0.4799 |
| 20 | 0 | 0.5063 |
| 30 | 0 | 0.4931 |
| | | |
| 0 | 5 | 0.4310 |
| 5 | 5 | 0.4699 |
| 10 | 5 | 0.4652 |
| 20 | 5 | 0.5114 |
| 30 | 5 | 0.6487 |

Table 4

| Electrolytic cell conditions | | N-6 Panels |
| --- | --- | --- |
| Time (minutes) | NaCl conc. (g/l) | Weight loss mg/cm$^2$ |
| 0 | 0 | 0.4921 |
| 5 | 0 | 0.5496 |
| 10 | 0 | 0.5485 |
| 20 | 0 | 0.5690 |
| 30 | 0 | 0.6300 |
| | | |
| 0 | 5 | 0.4921 |
| 5 | 5 | 0.5448 |
| 10 | 5 | 0.5523 |
| 20 | 5 | 0.6848 |
| 30 | 5 | 0.8590 |

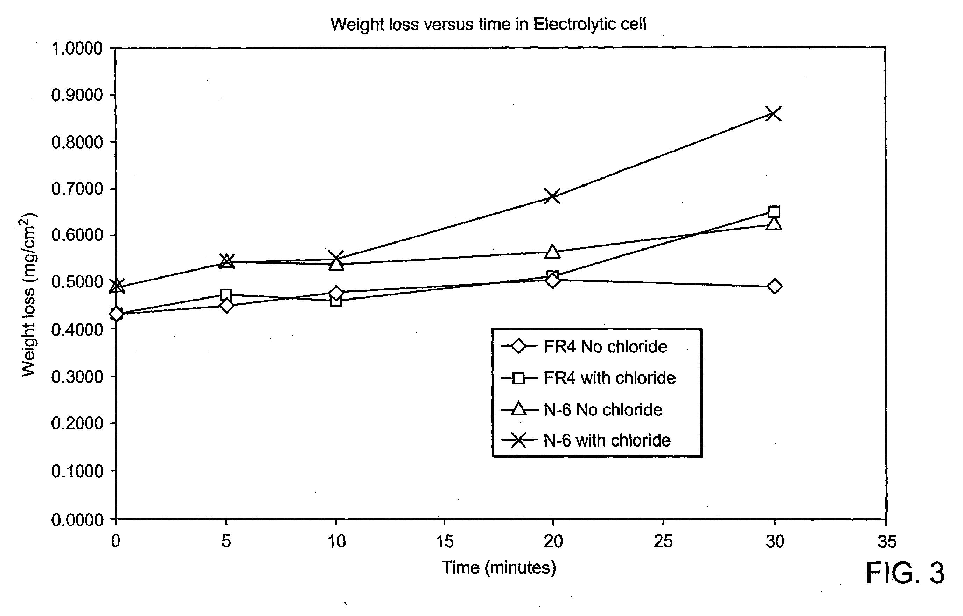

Figure 3 is a graph of the data from the tables. The graph of weight loss versus time shows that the longer the time in the electrolytic cell the higher was the weight loss of the panels due to the increased removal of resin accretions. Additionally, the addition of chloride to the electrolyte of the electrolytic cell caused the weight loss of the panels to increase further. The weight loss was believed to be caused by hydroxyl radicals attacking and removing resin accretions from the panels. The additional weight loss in the electrolytic cell with sodium chloride was believed caused by the hydroxyl radicals and chloride radicals attacking resin accretions.

Example 4

An experiment was carried out as described above in Example 3 except that the electrolyte of the electrolytic cell contained 140 grams/liter of sodium sulfate and 4 grams/liter of sodium hydroxide. The anode employed was a 7.5 x 5.5 cm double-sided lead dioxide anode and the cathode was a 7.5 x 5.5 cm double-sided iridium dioxide cathode. The results of the experiment are listed in the tables below.

Table 5

| Electrolytic cell conditions | | FR 4 Panels |
|---|---|---|
| Time (minutes) | NaCl conc. (g/l) | Weight loss mg/cm$^2$ |
| 0 | 0 | 0.4459 |
| 10 | 0 | 0.4525 |
| 30 | 0 | 0.4284 |
| | | |
| 0 | 5 | 0.4459 |
| 10 | 5 | 0.4146 |
| 30 | 5 | 0.4842 |

Table 6

| Electrolytic cell conditions | | N-6 Panels |
|---|---|---|
| Time (minutes) | NaCl conc. (g/l) | Weight loss mg/cm$^2$ |
| 0 | 0 | 0.4965 |
| 10 | 0 | 0.5688 |
| 30 | 0 | 0.6229 |
| | | |
| 0 | 5 | 0.4965 |
| 10 | 5 | 0.5801 |
| 30 | 5 | 0.6016 |

The general trend was observed again as in Example 3 above. As the time in which the panels remained in the electrolytic cell increased the weight loss of the panels increased. The weight loss was believed caused by hydroxyl radicals and chloride radicals attacking and removing resin accretions from the panels.

Example 5

A third experiment was carried out as in Example 3 above except that the electrolyte in the electrolytic cell contained 35 grams/liter of sodium hydroxide and the anode used was a 7.5 x 5.5 cm double-sided lead dioxide anode and the cathode was a 7.5 cm x 5.5 cm double-sided iridium dioxide cathode. The results of the experiment are disclosed in the tables below.

Table 7

| Electrolytic cell conditions | | FR4 Panels |
|---|---|---|
| Time (minutes) | NaCl conc. (g/l) | Weight loss mg/cm$^2$ |
| 0 | 0 | 0.4593 |
| 10 | 0 | 0.5240 |
| | | |
| 0 | 5 | 0.4593 |
| 10 | 5 | 0.4705 |

Table 8

| Electrolytic cell conditions | | N-6 Panels |
|---|---|---|
| Time (minutes) | NaCl conc. (g/l) | Weight loss mg/cm$^2$ |
| 0 | 0 | 0.5216 |
| 10 | 0 | 0.5626 |
| | | |
| 0 | 5 | 0.5216 |
| 10 | 5 | 0.6025 |

The data showed that weight loss increases with increasing dwell time in the electrolytic cell as in Examples 3 and 4. As in Examples 3 and 4 the weight loss was believed caused by the hydroxyl and chloride radicals desmearing resin accretions from the panels.

Example 6

Oxygen Evolution Determination for Iridium Dioxide Working Electrode

An anodic polarization scan was carried out by using a cell having three chambers, a central chamber and two side chambers. All the chambers were in fluid communication with each other. The fluid was a copper sulfate electrolyte at a pH = 1. The Pourbaix diagram used was a potential-pH equilibrium diagram for iridium and disclosed that an anode of iridium dioxide was stable at a pH of 1 for performing as an anode. The central chamber contained an insoluble iridium dioxide working electrode. One of the side chambers contained an brushed copper laminate counter electrode and the other side chamber contained a saturated calomel reference electrode.

The insoluble iridium dioxide working electrode was the electrode under test, i.e., the electrode used to determine the potential at which oxygen evolves. The anodic potential of the iridium dioxide anode was gradually increased and the resultant current density was measured. The anodic potential of the anode was increased using a potentiostat linked to a computer. The potentiostat employed was an EG and G Parc 273 that was driven by EG and G Soft Corr M352 Corrosion Measurement and Analysis software.

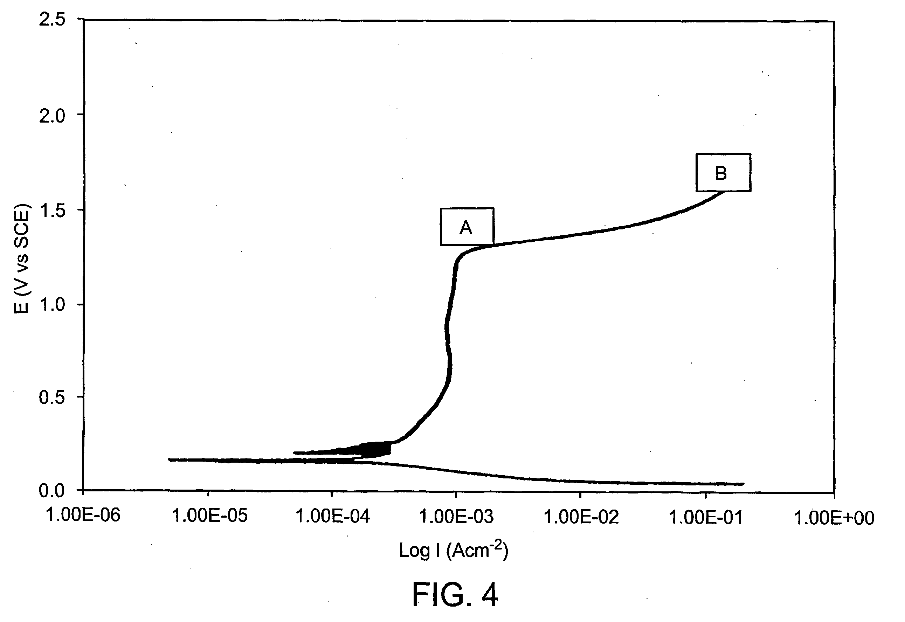

The program used to generate an anodic polarization curve as shown in Fig. 4 is shown in Table 9 below.

Table 9

| Program Name | Solidox® 3 |
|---|---|
| Counter electrode | Brushed copper laminate |
| Reference electrode | SCE |
| Working electrode | Iridium dioxide |
| Equilibration time (seconds) | 30 |
| Scan increment (mV) | 1 |
| Scan rate (mV/s) | 10 |
| Start potential (V) | 0.05 |
| End potential (V) | 1.75 |
| Working electrode area (cm$^2$) | 7.0 |

When an electrochemical reaction occurred at the anode an increase in the flux of electrons at the anode resulted and this in turn caused an increase in the current density. On the anodic polarization curve of Fig. 4 a wave or line occurred between points A and B. The near horizontal nature of this line indicated a rapid increase in current density and indicated that a chemical reaction occurred. Additionally, bubbles were given off at the anode surface when the potential of at 1.3 V was reached. The beginning of the curve at 1.3 V indicated the potential at which oxygen evolution occurred.

Example 7

Oxygen Evolution Determination for Lead Dioxide Working Electrode

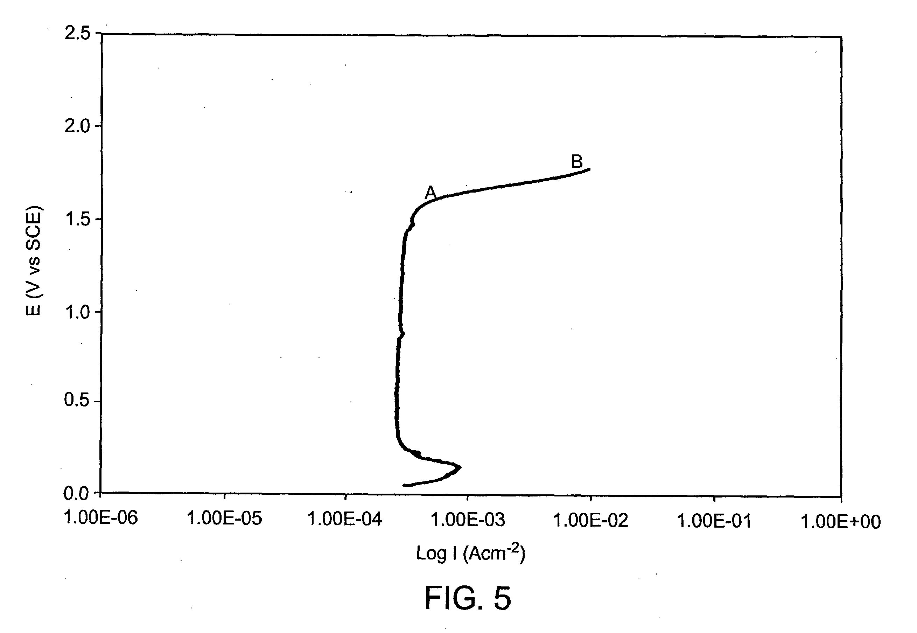

An anodic polarization scan was carried out by using a cell having three chambers, a central chamber and two side chambers. All the chambers were in fluid communication with each other. The fluid was a copper sulfate electrolyte at a pH = 1. The Pourbaix diagram used was a potential-pH equilibrium diagram for lead and disclosed that an anode of lead dioxide is stable at a pH of 1 for performing as an anode. The central chamber contained an insoluble lead dioxide working electrode. One of the side chambers contained brushed copper laminate counter electrode and the other side chamber contained a saturated calomel reference electrode.
The insoluble lead dioxide working electrode was the electrode under test, i.e., the electrode used to determine the potential at which oxygen evolves. The anodic potential of the lead dioxide anode was gradually increased and the resultant current density was measured. The anodic potential of the anode was increased using a potentiostat linked to a computer. The potentiostat employed was an EG and G Parc 273 that was driven by EG and G Soft Corr M352 Corrosion Measurement and Analysis software.
The program used to generate an anodic polarization curve as shown in Fig. 5 is shown in Table 10 below.

Table 10

| Program Name | Solidox® 3 |
| --- | --- |
| Counter electrode | Brushed copper laminate |
| Reference electrode | SCE |
| Working electrode | Lead dioxide |
| Equilibration time (seconds) | 30 |
| Scan increment (mV) | 1 |
| Scan rate (mV/s) | 10 |
| Start potential (V) | 0.05 |
| End potential (V) | 1.75 |
| Working electrode area (cm$^2$) | 7.0 |

When an electrochemical reaction occurred at the anode an increase in the flux of electrons at the anode resulted and this in turn caused an increase in the current density. On the anodic polarization curve of Fig. 5 a wave or line occurred between points A and B. The near horizontal nature of this line indicated a rapid increase in current density and indicated that a chemical reaction occurred. Additionally, bubbles were given off at the anode surface when the potential of at 1.6 V was reached. The beginning of the curve at 1.6 V indicated the potential at which oxygen evolution occurred.

**Claims**

1.  A method comprising:

    a. generating a free radical; and
    b. contacting a surface of a substrate having resin accretions thereon with the free radical to desmear the surface of the resin accretions and texture a resin.

2.  The method of claim 1, wherein the free radical comprises a hydroxyl, halogen radical, or mixtures thereof.

3.  The method of claim 1, wherein the free radical is generated electrolytically, chemically, by thermolysis, or by photolysis.

4.  The method of claim 3, wherein the free radical is generated electrolytically at an electrical potential above an electrical potential for generating oxygen.

**5.** The method of claim 4, wherein the free radical is generated at a surface of an anode of an electrolytic cell.

**6.** The method of claim 2, wherein the hydroxyl radicals are generated from ozone or hydrogen peroxide or mixtures thereof.

**7.** The method of claim 3, wherein the free radical is generated chemically with a reagent comprising a ferrous salt and hydrogen peroxide.

**8.** A method of desmearing comprising:

a. generating a free radical;
b. contacting a surface of a substrate having resin accretions with the free radical to remove a portion of the resin accretions; and
c. contacting the surface of the substrate with a promoter to remove additional resin accretions from the surface of the substrate and texture a resin.

**9.** The method of claim 8, wherein the promoter comprises a permanganate etch solution.

**10.** The method of claim 8, wherein the substrate is a printed wiring board and the surface having the resin accretions is a through-hole wall.

Board No. 13
4120: (N)
Electro Process: (Y)
4130 (Y)
4190 Y)
2.0K X

FIG. 1

FIG. 2

Weight loss versus time in Electrolytic cell

FIG. 3

EP 1 420 620 A2

FIG. 4

EP 1 420 620 A2

FIG. 5

EP 1 420 620 A2